# EUROPEAN PATENT APPLICATION

(11) **EP 4 718 732 A1**
(43) Date of publication of application: **01.04.2026**
(21) Application number: 25173523.9
(22) Date of filing: 30.04.2025
(51) Int. Cl.: H03M 13/15, H03M 13/25, H03M 13/37, H03M 13/45, H03M 13/00, H04L 1/00, H03M 13/09, H03M 13/27, H03M 13/29, H03M 13/51, G06F 13/42

(54) **FLIT DECODER GENERATING DECODED PACKET FRAGMENT, COMMUNICATION DEVICE INCLUDING THE SAME, AND METHOD OF OPERATING THE SAME**

(30) Priority: 25.09.2024 KR 20240130139; 14.03.2025 US 202519080239
(71) Applicant: Samsung Electronics Co., Ltd., Suwon-si, Gyeonggi-do 16677 (KR)
(72) Inventor: LIM, Jinsoo, 16677 Suwon-si (KR); SEOL, Changkyu, 16677 Suwon-si (KR); KIM, Daewook, 16677 Suwon-si (KR); PARK, Dongjin, 16677 Suwon-si (KR); KIM, Jiho, 16677 Suwon-si (KR)
(74) Representative: Marks & Clerk LLP

(57) **Abstract**

A flit decoder includes an error correction code (ECC) decoder that generates an ECC decoded packet fragment based on a packet fragment, an interleaver circuit that generates an interleaved packet based on the ECC decoded packet fragment, a cyclic redundancy check (CRC) decoder that generates an enable signal in response to a failure of a CRC decoding operation of the interleaved packet, a reliability calculator that generates bit stream information for identifying first to N-th error-estimated symbols of the packet fragment, and a post decoder. The post decoder generates first to N-th index values corresponding to the first to N-th error-estimated symbols, respectively, generates first to M-th candidate information indicating two combined of the first to N-th index values, generates first to M-th erasure decoded packet fragments, and provides a selected one of the first to M-th erasure decoded packet fragments to the interleaver circuit.

## Description

### BACKGROUND

The present disclosure relates to packet decoding, and more particularly, to a flit decoder that generates a decoded packet fragment, a communication device including the same, and a method of operating the same.

An electronic system manages packets representing various information. The electronic system may include various components such as a processor, a memory, etc. The components may communicate packets through a communication interface circuit. The communication device may provide an encoded packet to another communication device to ensure reliability of the packet and may decode a packet received from another communication device. The communication device may correct error bits of the packet by performing a decoding operation of the packet.

The communication device may have an error correction capability. The communication device may correct error bits of the packet when the error level (e.g., the number of error bits of the packet) of the packet does not exceed the error correction capability. The communication device may request re-transmission of the packet from another communication device when the error level of the packet exceeds the error correction capability. Re-transmission of the packet may reduce the communication speed between communication devices within the transmission system.

### SUMMARY

It is an aspect to provide a flit decoder for generating a decoded packet fragment, a communication device including the same, and a method of operating the same.

According to an aspect of one or more embodiments, there is provided a flit decoder comprising an error correction code (ECC) decoder configured to generate a first ECC decoded packet fragment based on a first packet fragment; an interleaver circuit configured to generate a first interleaved packet based on the first ECC decoded packet fragment; a cyclic redundancy check (CRC) decoder configured to generate an enable signal based on a failure of a first CRC decoding operation of the first interleaved packet; a reliability calculator configured to generate bit stream information for identifying first to N-th error-estimated symbols among a plurality of symbols of the first packet fragment; and a post decoder. The post decoder is configured to, in response to the enable signal, generate first to N-th index values corresponding to the first to N-th error-estimated symbols, respectively, based on the bit stream information; generate first to M-th candidate information indicating two of the first to N-th index values, which are combined without duplication and without considering an order; generate first to M-th erasure decoded packet fragments based on the first packet fragment and the first to M-th candidate information; and provide a selected one of the first to M-th erasure decoded packet fragments to the interleaver circuit. "N" is a natural number less than a number of the plurality of symbols, and "M" is _{N}C₂.

According to another aspect of one or more embodiments, there is provided a communication device comprising an input/output (I/O) circuit including a plurality of transmitters and a plurality of receivers; a flit encoder configured to provide a first packet to the plurality of transmitters; and a flit decoder configured to receive a second packet from the plurality of receivers. The flit decoder includes an error correction code (ECC) decoder configured to generate an ECC decoded packet fragment based on a packet fragment of the second packet; an interleaver circuit configured to generate an interleaved packet based on the ECC decoded packet fragment; a cyclic redundancy check (CRC) decoder configured to generate an enable signal based on a failure of a CRC decoding operation of the interleaved packet; a reliability calculator configured to generate bit stream information for identifying first to N-th error-estimated symbols among a plurality of symbols of the packet fragment; and a post decoder. The post decoder is configured to, in response to the enable signal, generate first to N-th index values corresponding to the first to N-th error-estimated symbols, respectively, based on the bit stream information; generate first to M-th candidate information indicating two of the first to N-th index values, which are combined without duplication and without considering an order; generate first to M-th erasure decoded packet fragments based on the first packet and the first to M-th candidate information; and provide a selected one of the first to M-th erasure decoded packet fragments to the interleaver circuit. "N" is a natural number less than a number of the plurality of symbols, and "M" is _{N}C₂.

According to yet another aspect of one or more embodiments, there is provided a method of operating a flit decoder, the method comprising receiving a packet including a first packet fragment, a second packet fragment, and a third packet fragment; generating a first error correction code (ECC) decoded packet fragment, a second ECC decoded packet fragment, and a third ECC decoded packet fragment, based on the first packet fragment, the second packet fragment, and the third packet fragment; generating a first interleaved packet based on the first ECC decoded packet fragment, the second ECC decoded packet fragment, and the third ECC decoded packet fragment; generating an enable signal based on a failure of a first cyclic redundancy check (CRC) decoding operation of the first interleaved packet; generating bit stream information for identifying first to N-th error-estimated symbols among a plurality of symbols of the first packet fragment, "N" being a natural number less than a number of the plurality of symbols; generating first to N-th index values corresponding to the first to N-th error-estimated symbols, respectively, based on the enable signal and the bit stream information; generating first to M-th candidate information indicating two of the first to N-th index values, which are combined without duplication and without considering an order, "M" being _{N}C₂; generating first to M-th erasure decoded packet fragments based on the first packet fragment and the first to M-th candidate information; selecting one of the first to M-th erasure decoded packet fragments as a post-decoded packet fragment; and generating a second interleaved packet based on the post-decoded packet fragment, the second ECC decoded packet fragment, and the third ECC decoded packet fragment.

At least some of the above and other features of the invention are set out in the claims.

### BRIEF DESCRIPTION OF THE FIGURES

The above and other aspects will become apparent by describing in detail embodiments thereof with reference to the accompanying drawings, in which:
FIG. 1 is a block diagram illustrating an electronic system according to an embodiment;
FIG. 2 is a block diagram illustrating a communication device of the electronic system of FIG. 1, according to some embodiments;
FIG. 3 is a block diagram illustrating a flit decoder of the communication device of FIG. 2, according to some embodiments;
FIG. 4 is a graph illustrating a voltage level of a packet, according to some embodiments;
FIG. 5 is a table illustrating a packet in a flit mode, according to some embodiments;
FIG. 6 is a diagram illustrating packet fragments of a packet in a flit mode, according to some embodiments;
FIG. 7 is a diagram illustrating interleaved packets, according to some embodiments;
FIG. 8 is a flowchart illustrating how a flit decoder operates.
FIG. 9 is a flowchart illustrating a method of operating a flit decoder, according to some embodiments;
FIG. 10 is a diagram illustrating a method of operating a flit decoder, according to some embodiments;
FIG. 11 is a diagram illustrating bit stream information of the flit decoder of FIG. 10, according to some embodiments;
FIG. 12 is a diagram illustrating a decoded packet fragment of the flit decoder of FIG. 10, according to some embodiments;
FIG. 13 is a diagram illustrating a post decoder of the flit decoder of FIG. 10, according to some embodiments;
FIG. 14 is a diagram illustrating an erasure position calculator of the post decoder of FIG. 13, according to some embodiments; and
FIG. 15 is a flowchart illustrating a method of operating a flit decoder, according to some embodiments.

### DETAILED DESCRIPTION

Hereinafter, various embodiments will be described clearly and in detail such that those skilled in the art may easily carry out the various embodiments.

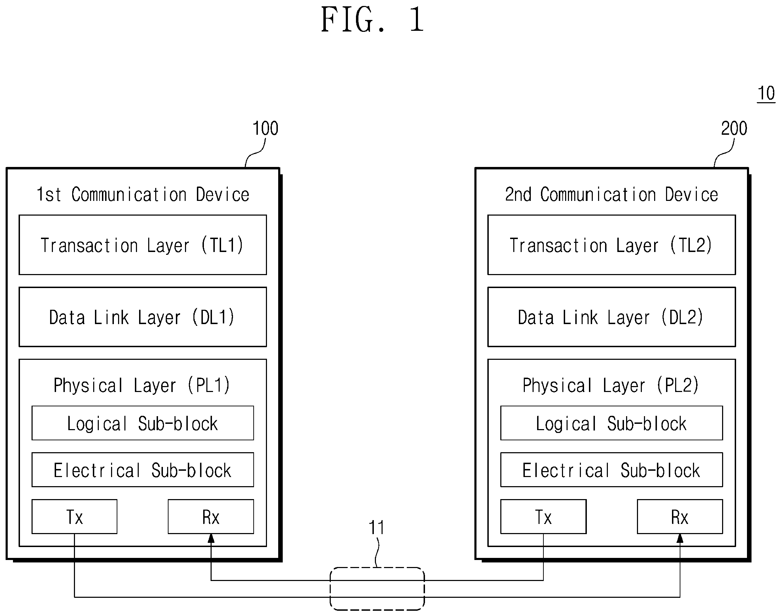

FIG. 1 is a block diagram illustrating an electronic system according to an embodiment. Referring to FIG. 1, an electronic system 10 may manage various information or various data. For example, the electronic system 10 may be implemented as a computing system, which is configured to process various information, such as a personal computer (PC), a notebook, a laptop, a server, a workstation, a tablet PC, a smartphone, a digital camera, and/or a black box. In some embodiments, the electronic system 10 may be implemented as a storage system, a server system, a database server, etc. for managing a large amount of user data.

The electronic system 10 may include a plurality of components for managing various information or various data. For example, the plurality of components may be implemented as a processor, a volatile memory device, a non-volatile memory device, a network interface card (NIC), a graphics card, etc. The components may function as devices (e.g., a first communication device 100 and a second communication device 200) for communicating packets. The packet may represent various information or various data.

The electronic system 10 may include a communication interface circuit 11, the first communication device 100, and the second communication device 200. The first communication device 100 and the second communication device 200 may also be referred to as a first component and a second component of the electronic system 10, respectively. The first communication device 100 and the second communication device 200 may communicate packets through the communication interface circuit 11.

The communication interface circuit 11 may provide an interface between the first communication device 100 and the second communication device 200. For example, in an embodiment, the communication interface circuit 11 may be implemented as a peripheral component interconnect express (PCIe) communication interface circuit. The communication interface circuit 11 may support a PCIe link between the first communication device 100 and the second communication device 200.

The first communication device 100 may include a transaction layer TL1, a data link layer DL1, and a physical layer PL1. The transaction layer TL1, the data link layer DL1, and the physical layer PL1 may also be referred to as a top layer, an intermediate layer, and a bottom layer, respectively.

The transaction layer TL1 is responsible for decomposing and assembling a transaction layer packet TLP. The TLP is used to communicate transactions such as reads and writes as well as specific types of events. The transaction layer TL1 manages credit-based flow control with respect to the TLP. All request packets that require a response packet are implemented as a split transaction. Each packet includes a unique identifier that allows the response packets to be transferred to a correct originator. The packet format supports different types of addresses depending on the type of transaction (e.g., a memory, an input/output (I/O), a configuration, a message, etc.). The transaction layer supports four address spaces, which include three PCI address spaces (e.g., a memory, an I/O, and a configuration) and a message space.

The data link layer DL1 acts as an intermediate stage between the transaction layer TL1 and the physical layer PL1. The data link layer DL1 is responsible for link management and data integrity, including error detection and error correction. The transmitting side of the data link layer DL1 accepts the TLPs assembled by the transaction layer TL1, calculates and applies a data protection code and a TLP sequence number, and submits them to the physical layer PL1 for transmission through the communication interface circuit 11. The receiving side of the data link layer DL1 checks the integrity of the received TLPs and submits them to the transaction layer TL1 for further processing. When TLP error(s) are detected, the data link layer DL1 requests re-transmission of the TLPs until the information is correctly received or the PCIe link is determined to have failed. The data link layer DL1 generates and consumes packets used for PCIe link management functions. To distinguish packets from the TLPs used by the transaction layer TL1, the packets generated and consumed by the data link layer DL1 may be referred to as data link layer packets (DLPs).

The physical layer PL1 may include circuits for interface operation, such as drivers, input buffer circuits, parallel-to-serial (PS) conversion circuits, serial-to-parallel (SP) conversion circuits, phase locked loop (PLL) circuits, and/or impedance matching circuits. The physical layer PL1 performs logical functions related to interface initialization and interface maintenance. The physical layer PL1 may exchange information according to a specific format with the data link layer DL1. The physical layer PL1 may convert information received from the data link layer DL1 into an appropriate serialized format, and may transmit the converted information through the communication interface circuit 11 at a frequency and a bandwidth compatible with other components (e.g., the second communication device 200).

The physical layer PL1 may include a transmitter Tx, a receiver Rx, a logical sub-block, and an electrical sub-block. The transmitter Tx may transmit a packet to the receiver Rx of the second communication device 200 through the communication interface circuit 11. The receiver Rx may receive a packet from the transmitter Tx of the second communication device 200 through the communication interface circuit 11.

The logical sub-block may include a transmission section that prepares information received from the data link layer DL1 for transmission by the electrical sub-block, and a reception section that identifies and prepares information received through the communication interface circuit 11 to be transferred to the data link layer DL1. The logical sub-block directs control and management of functions of the physical layer PL1. The logical sub-block may support two data stream modes. The two data stream modes may include a flit mode and a non-flit mode.

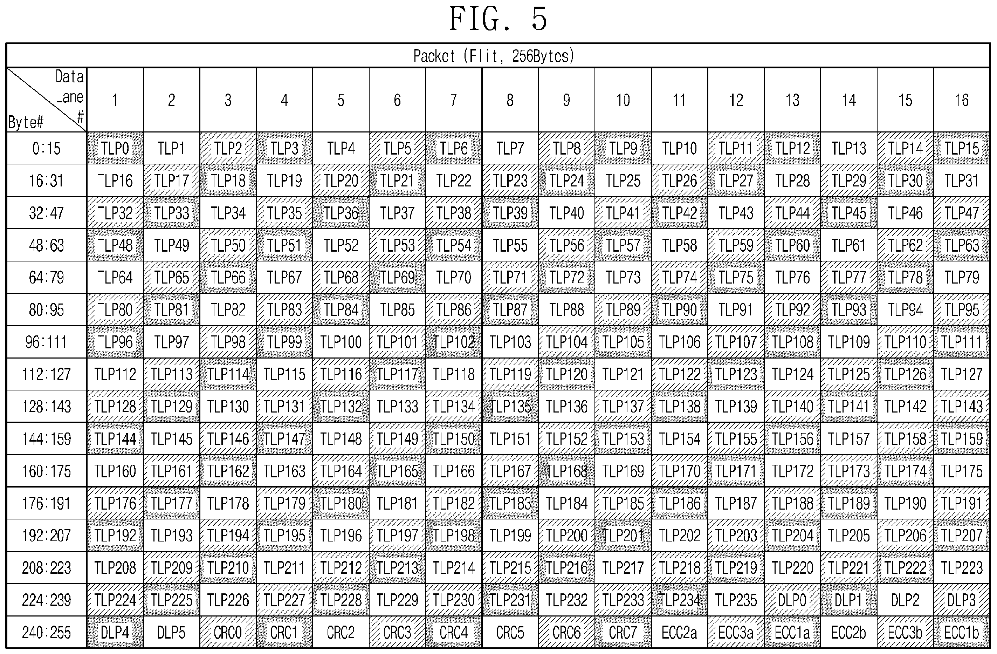

The flit mode may be supported in PCIe 6.0 or a later generated (e.g. the next generation) of PCIe (e.g., PCIe 7.0). A packet in the flit mode may include TLP symbols, DLP symbols, cyclic redundancy check (CRC) symbols, error correction code (ECC) symbols, etc. A more detailed description of a packet in the flit mode will be described later with reference to FIG. 5. In flit decoding, a "flit" may be a packet of data of a predefined size (e.g. 256 bytes). The size may be defined by a standard (e.g. a PCIe standard, such as PCIe 6.0). In flit mode, a flit (e.g. a packet) may be decoded (e.g. based on ECC and CRC). The non-flit mode may refer to a case where the flit mode is not applied.

The electrical sub-block supports non return to zero (NRZ) signaling, pulse amplitude modulation 4-level (PAM-4) signaling, a reference clock architecture, a spread spectrum clock, a reduced swing mode for low power link operation, in-band receiver detection and electrical idle detection, a channel compliance methodology, adaptive transmitter equalization and reference receiver equalization, data lane merging, and alternative current (AC)-coupled channels. For example, the electrical sub-block may perform an analog-to-digital conversion (ADC) operation and equalization of an electrical signal received through the communication interface circuit 11, and may provide the converted signal to the logical sub-block.

The second communication device 200 may include a transaction layer TL2, a data link layer DL2, and a physical layer PL2. The physical layer PL2 may include the transmitter Tx, the receiver Rx, the logical sub-block, and the electrical sub-block, similar to the physical layer PL1 of the first communication device 100. The features of the transaction layer TL2, the data link layer DL2, and the physical layer PL2 of the second communication device 200 are similar to the features of the transaction layer TL1, the data link layer DL1, and the physical layer PL1 of the first communication device 100, and therefore, additional descriptions thereof are omitted to avoid redundancy.

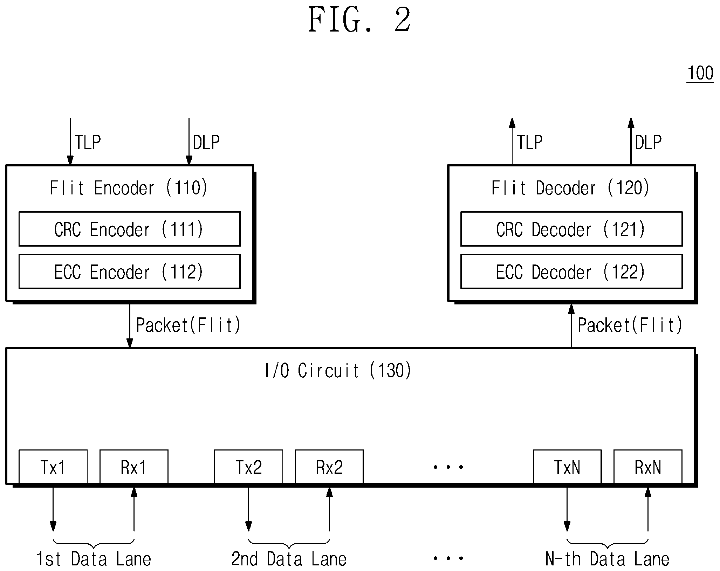

FIG. 2 is a block diagram illustrating a communication device of FIG. 1, according to some embodiments. Referring to FIGS. 1 and 2, the first communication device 100 may include a flit encoder 110, a flit decoder 120, and an I/O circuit 130.

The flit encoder 110 may correspond to the data link layer DL1 and the physical layer PL1. For example, the flit encoder 110 may be implemented as a part of the data link layer DL1, a part of the physical layer PL1, or a combination thereof.

The flit encoder 110 may support the flit mode of the PCIe standard. The flit encoder 110 may encode a packet that complies with a format of the flit mode. In the flit mode, the packet may include Reed Solomon (RS) code-based symbols. The RS code-based symbol may have a size of 1 byte and may correspond to four PAM-4 symbols each having a size of 2 bits.

In more detail, the flit encoder 110 may receive the TLP from the transaction layer TL1 or the data link layer DL1. The TLP may be a set of TLP symbols, and one TLP symbol may have a size of 1 byte (i.e., 8 bits). The flit encoder 110 may receive the DLP from the data link layer DL1. The DLP may be a set of DLP symbols, and one DLP symbol may have a size of 1 byte.

The flit encoder 110 may include a CRC encoder 111 and an ECC encoder 112. The CRC encoder 111 may generate CRC parity symbols based on a CRC encoding operation. One CRC parity symbol may have a size of 1 byte. The CRC parity symbol may be used to determine whether error correction by a CRC parity symbol passes or fails. Passing may mean that the integrity of error-corrected symbols is verified. Failure may mean that the integrity of the error-corrected symbols is not verified.

The ECC encoder 112 may generate ECC parity symbols based on an ECC encoding operation. One ECC parity symbol may have a size of 1 byte. The ECC parity symbol may be used to correct an error symbol among symbols encoded together by the ECC encoding operation. An error symbol may be an erroneous, or incorrect symbol (e.g. a received symbol that differs from the corresponding transmitted symbol). When the position of the error symbol is specified, more error symbols may be corrected by the same ECC parity symbol.

The flit encoder 110 may generate a packet of the flit mode based on the TLP symbols, the DLP symbols, the CRC parity symbols, and the ECC parity symbols. The flit encoder 110 may provide the packet of the flit mode to first to N-th transmitters Tx1 to TxN of the I/O circuit 130. The packet may be provided to the second communication device 200 by the I/O circuit 130.

The flit decoder 120 may correspond to the data link layer DL1 and the physical layer PL1. For example, the flit decoder 120 may be implemented as a part of the data link layer DL1, a part of the physical layer PL1, or a combination thereof.

The flit decoder 120 may support the flit mode of the PCIe standard. The flit decoder 120 may decode a packet that complies with a format of the flit mode. In more detail, the flit decoder 120 may receive a packet of the flit mode from a plurality of receivers Rx1 to RxN of the I/O circuit 130. The packet may be a packet received from the second communication device 200 by the I/O circuit 130. The packet in the flit mode may include the TLP symbols, the DLP symbols, the CRC parity symbols, and the ECC parity symbols.

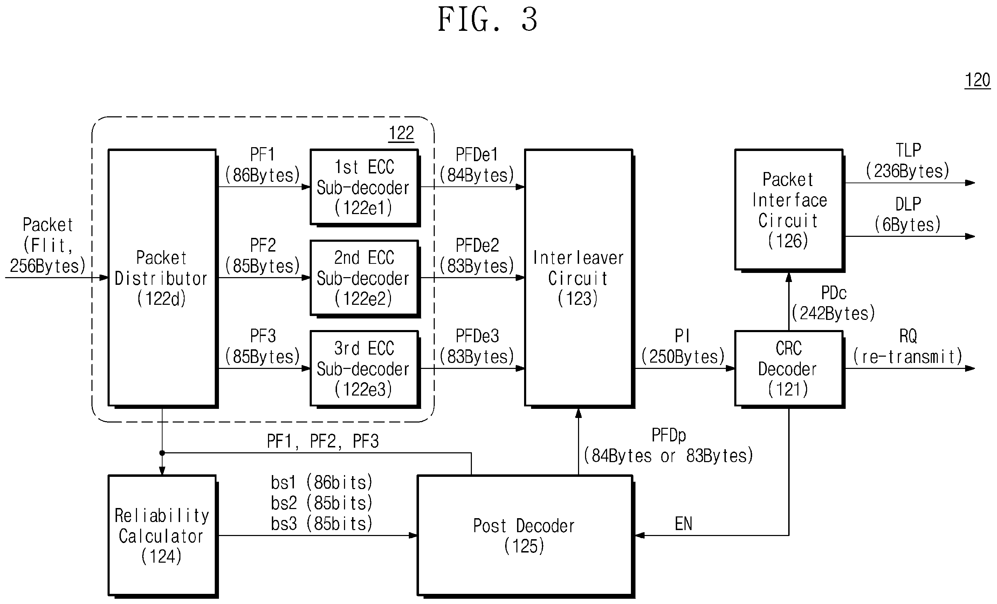

The flit decoder 120 may include a CRC decoder 121 and an ECC decoder 122. The ECC decoder 122 may perform an ECC decoding operation based on a packet in the flit mode. The CRC decoder 121 may perform a CRC decoding operation based on an ECC decoded packet. When the CRC decoding operation fails, the CRC decoder 121 may request a post decoding operation or may request re-transmission of the packet to the second communication device 200. A more detailed description of the post decoding operation will be described later with reference to FIG. 3. The CRC decoder 121 may provide the TLP to the transaction layer TL1 or the data link layer DL1 when the CRC decoding operation passes, and may provide the DLP to the data link layer DL1.

The I/O circuit 130 may correspond to the physical layer PL1. For example, the I/O circuit 130 may be implemented as a part of the physical layer PL1.

The I/O circuit 130 may be connected to first to N-th data lanes. For example, "N" may be 1, 2, 4, 8, or 16, but embodiments are not necessarily limited thereto, and the number of data lanes, "N", may be variously changed. The data lane may refer to a PCIe lane of the communication interface circuit 11. The data lane may correspond to a pair of transmitters and receivers (e.g. one transmitter and one receiver (a transmitter-receiver pair)). The transmitter may output a packet having a format of a differential signal to the data lane. Accordingly, each transmitter may comprise two transmission lines (a transmit differential pair) to allow a differential signal to be transmitted. The receiver may receive a packet having a format of a differential signal from the data lane. Accordingly, each receiver may comprise two reception lines (a receive differential pair) to allow a differential signal to be received.

The I/O circuit 130 may include the first to N-th transmitters Tx1 to TxN and the first to N-th receivers Rx1 to RxN. The first transmitter Tx1 and the first receiver Rx1 may be connected to the first data lane. The second transmitter Tx2 and the second receiver Rx2 may be connected to the second data lane. As in the above description, the N-th transmitter TxN and the N-th receiver RxN may be connected to the N-th data lane.

The first to N-th transmitters Tx1 to TxN may receive packets in the flit mode from the flit encoder 110 and may provide the packets in the flit mode to the second communication device 200 through the first to N-th data lanes.

The first to N-th receivers Rx1 to RxN may receive packets in the flit mode from the second communication device 200 through the first to N-th data lanes, and may provide the packets in the flit mode to the flit decoder 120.

FIG. 3 is a block diagram illustrating a flit decoder of FIG. 2, according to some embodiments. Referring to FIGS. 2 and 3, the flit decoder 120 may include the CRC decoder 121, the ECC decoder 122, an interleaver circuit 123, a reliability calculator 124, a post decoder 125, and a packet interface circuit 126.

The ECC decoder 122 may receive a packet in the flit mode. The packet may have a size of 256 bytes. The packet may include a first packet fragment PF1, a second packet fragment PF2, and a third packet fragment PF3. The ECC decoder 122 may generate the first to third packet fragments PF1 to PF3 based on a distribution operation of a packet, and may generate a first ECC decoded packet fragment PFDe1, a second ECC decoded packet fragment PFDe2, and a ECC decoded packet fragment PFDe3 based on ECC decoding operations of the first to third packet fragments PF1 to PF3.

The ECC decoder 122 may include a packet distributor 122d, a first ECC sub-decoder 122e1, a second ECC sub-decoder 122e2, and a third ECC sub-decoder 122e3.

The packet distributor 122d may generate the first packet fragment PF1, the second packet fragment PF2, and the third packet fragment PF3 based on a distribution operation of a packet. The first packet fragment PF1 may have a size of 86 bytes. The second packet fragment PF2 may have a size of 85 bytes. The third packet fragment PF3 may have a size of 85 bytes.

The packet distributor 122d may provide the first packet fragment PF1 to the first ECC sub-decoder 122e1. The packet distributor 122d may provide the second packet fragment PF2 to the second ECC sub-decoder 122e2. The packet distributor 122d may provide the third packet fragment PF3 to the third ECC sub-decoder 122e3. The packet distributor 122d may provide the first to third packet fragments PF1 to PF3 to the reliability calculator 124. The packet distributor 122d may provide the first to third packet fragments PF1 to PF3 to the post decoder 125.

The first ECC sub-decoder 122e1 may generate the first ECC decoded packet fragment PFDe1 based on the ECC decoding operation of the first packet fragment PF1. The first ECC decoded packet fragment PFDe1 may have a size of 84 bytes. For example, the first packet fragment PF1 may include two ECC parity symbols. The first ECC sub-decoder 122e1 may perform an ECC decoding operation on the remaining 84 symbols of the first packet fragment PF1 based on the two ECC parity symbols to generate the first ECC decoded packet fragment PFDe1.

The first ECC sub-decoder 122e1 may correct one error symbol among the symbols of the first packet fragment PF1. The first ECC sub-decoder 122e1 may perform the ECC decoding operation regardless of the position of the error symbol (e.g., which symbol is the error symbol among the 86 symbols corresponding to the first packet fragment PF1). When the first packet fragment PF1 includes two or more error symbols, the ECC decoding operation of the first ECC sub-decoder 122e1 may fail. Thereafter, the CRC decoder 121 may fail the CRC decoding operation.

As in the above description, the second ECC sub-decoder 122e2 may generate the second ECC decoded packet fragment PFDe2 based on the ECC decoding operation of the second packet fragment PF2. The second ECC decoded packet fragment PFDe2 may have a size of 83 bytes. The second packet fragment PF2 may include two ECC parity symbols. The third ECC sub-decoder 122e3 may generate the third ECC decoded packet fragment PFDe3 based on the ECC decoding operation of the third packet fragment PF3. The third ECC decoded packet fragment PFDe3 may have a size of 83 bytes. The third packet fragment PF3 may include two ECC parity symbols.

The interleaver circuit 123 may receive the first to third ECC decoded packet fragments PFDe1 to PFDe3 from the first to third ECC sub-decoders 122e1 to 122e3, respectively. The interleaver circuit 123 may buffer the first to third ECC decoded packet fragments PFDe1 to PFDe3. The interleaver circuit 123 may generate an interleaved packet PI based on an interleaving operation of the first to third ECC decoded packet fragments PFDe1 to PFDe3. The interleaved packet PI may have a size of 250 bytes.

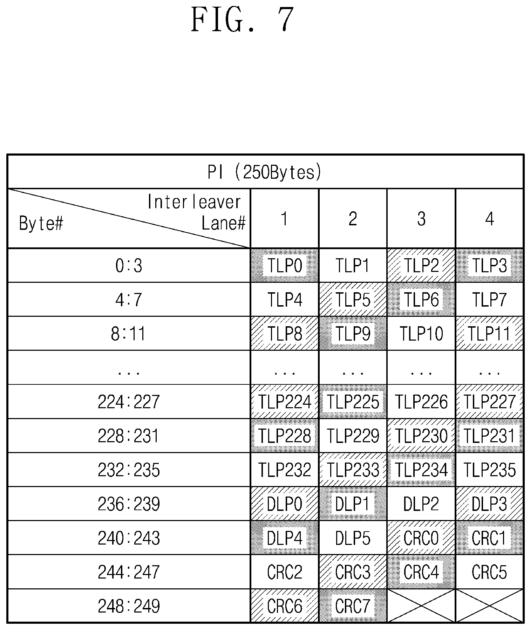

The interleaving operation may be to sequentially mix the first to third ECC decoded packet fragments PFDe1 to PFDe3. A more detailed description of the interleaving operation will be described later with reference to FIG. 7.

The CRC decoder 121 may receive the interleaved packet PI from the interleaver circuit 123. The CRC decoder 121 may perform a CRC decoding operation of the interleaved packet PI. When the CRC decoding operation passes, the CRC decoder 121 may provide a CRC decoded packet PDc to the packet interface circuit 126. The CRC decoded packet PDc may have a size of 242 bytes. For example, the interleaved packet PI may include 8 CRC parity symbols. The CRC decoder 121 may determine whether the CRC decoding operation for the remaining 242 symbols of the interleaved packet PI passes or fails based on the 8 CRC parity symbols, and when the CRC decoding operation passes, the CRC decoder 121 may generate the CRC decoded packet PDc.

The packet interface circuit 126 may receive the CRC decoded packet PDc from the CRC decoder 121. The CRC decoded packet PDc may include the TLP and the DLP. The TLP may have a size of 236 bytes. The TLP may include 236 TLP symbols. The DLP may have a size of 6 bytes. The DLP may include 6 DLP symbols. The packet interface circuit 126 may provide the TLP to the transaction layer TL1 or the data link layer DL1 of FIG. 1. The packet interface circuit 126 may provide the DLP to the data link layer DL1 of FIG. 1.

Referring back to the CRC decoder 121, the CRC decoder 121 may provide an enable signal EN to the post decoder 125 when the CRC decoding operation fails. The enable signal EN may activate the post decoding operation of the post decoder 125.

The reliability calculator 124 may receive the first to third packet fragments PF1 to PF3 from the packet distributor 122d. The reliability calculator 124 may generate first bit stream information bs1, second bit stream information bs2, and third bit stream information bs3 based on the first to third packet fragments PF1 to PF3.

For example, the first packet fragment PF1 may include 86 symbols, and each of the symbols may correspond to four PAM-4 symbols. Each PAM-4 symbol may have a voltage level. When a PAM-4 symbol (e.g. at least one PAM-4 symbol) having an unreliable voltage level is detected among four PAM-4 symbols corresponding to one symbol, the reliability calculator 124 may assign a first bit value (e.g., '1') to the corresponding symbol. In contrast, when all four PAM-4 symbols corresponding to one symbol are detected as having reliable voltage levels, the reliability calculator 124 may assign a second bit value (e.g., '0') to the corresponding symbol.

The first bit stream information bs1 may identify the positions of symbols estimated to be erroneous among the symbols of the first packet fragment PF1. The first bit stream information bs1 may have a size of 86 bits. The second bit stream information bs2 may identify the positions of symbols estimated to be erroneous among the symbols of the second packet fragment PF2. The second bit stream information bs2 may have a size of 85 bits. The third bit stream information bs3 may identify the positions of symbols estimated to be erroneous among the symbols of the third packet fragment PF3. The third bit stream information bs3 may have a size of 85 bits.

The post decoder 125 may receive the enable signal EN from the CRC decoder 121, may receive the first to third packet fragments PF1 to PF3 from the packet distributor 122d, and may receive the first to third bit stream information bs1 to bs3 from the reliability calculator 124. The post decoder 125 may perform a post decoding operation on at least one of the first to third packet fragments PF1 to PF3 based on the first to third bit stream information bs1 to bs3 in response to the enable signal EN, thereby generating at least one post decoded packet fragment PFDp.

The post decoder 125 may replace at least one of the first to third ECC decoded packet fragments PFDe1 to PFDe3 buffered by the interleaver circuit 123 with at least one post decoded packet fragment PFDp. The interleaver circuit 123 may further perform an interleaving operation based on the replaced at least one post decoded packet fragment PFDp to generate another interleaved packet PI. The CRC decoder 121 may perform the CRC decoding operation of another interleaved packet PI. The CRC decoder 121 may generate a request signal RQ for re-transmission of a packet in the flit mode when the CRC decoding operation of another interleaved packet PI fails, and may provide the request signal RQ to the second communication device 200 of FIG. 1 through the I/O circuit 130 of FIG. 2.

The post decoded packet fragment PFDp may correspond to one of the first to third ECC decoded packet fragments PFDe1 to PFDe3. The post decoder 125 may perform the post decoding operation of the corresponding packet fragment when there are two or more bits having the first bit value (e.g., '1') in the corresponding bit stream. There may be one, two, or three post decoded packet fragments PFDp.

The post decoding operation may include performing erasure decoding on a combination of error-estimated symbols based on the corresponding bit stream, and selecting one of the erasure decoded packet fragments as the post decoded packet fragment PFDp. The erasure decoding may be the error correction of two error symbols whose positions are specified. For instance, in erasure decoding, the error symbols whose positions are specified by be erased (e.g. set to a corresponding symbol, such as "00") and the erased data may be recovered through erasure decoding (e.g. based on erasure code, such as Reed Solomon code in the packet fragment). Erasure decoding may recover lost (e.g. erased) data, when the location of the lost data is known. This is in contrast to error correction code, which identifies and corrects erroneous data.

By the post decoding operation, two error symbols whose positions are specified among the symbols of the first packet fragment PF1 may be corrected. Thereafter, the CRC decoder 121 may pass the CRC decoding operation. In contrast, when the first packet fragment PF1 includes three or more error symbols, the post decoding operation may fail. Thereafter, the CRC decoder 121 may fail the CRC decoding operation. As in the above description, by the post decoding operation, two error symbols whose positions are specified among the symbols of the second packet fragment PF2 may be corrected. By the post decoding operation, two error symbols whose positions are specified among the symbols of the third packet fragment PF3 may be corrected.

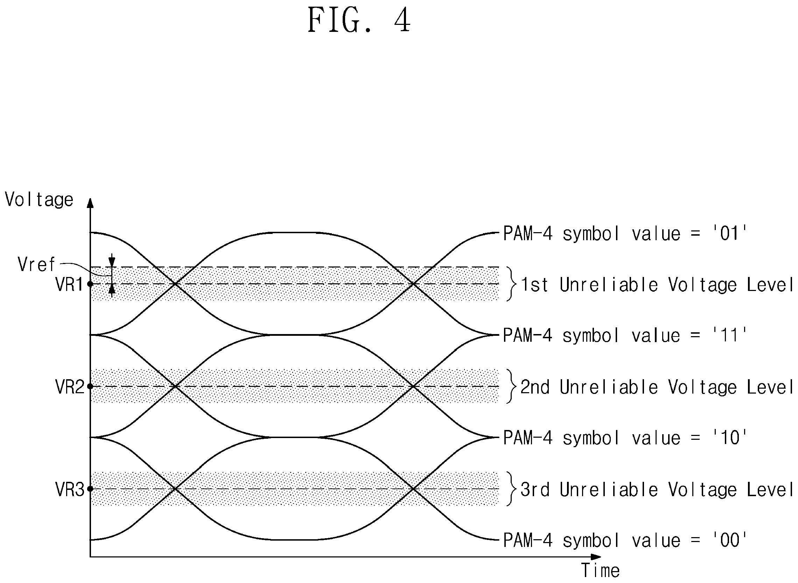

FIG. 4 is a graph illustrating a voltage level of a packet, according to some embodiments. Referring to FIGS. 3 and 4, a packet may include 256 symbols. Each of the symbols may include four PAM-4 symbols. A PAM-4 symbol may correspond to two bits. The PAM-4 symbol may have a voltage level corresponding to a PAM-4 symbol value. Referring to the graph, an eye diagram of the PAM-4 symbols is illustrated. The eye diagram may illustrate voltage levels measured at the receiver Rx of the physical layer PL1 of the first communication device 100 of FIG. 1. A horizontal axis represents a time. A vertical axis represents a voltage.

The PAM-4 symbol may correspond to one of PAM-4 symbol values '00', '10', '11', and '01'. The PAM-4 symbol may have one of first to third unreliable voltage levels. In the graph, the first to third unreliable voltage levels are illustrated as shaded areas. The first to third unreliable voltage levels may collectively be referred to as unreliable voltage levels of the PAM-4 symbol. Each unreliable voltage level may be a predefined range of voltages around a boundary between PAM-4 symbol values.

The first voltage level VR1 may refer to the middle of the voltage levels corresponding to the PAM-4 symbol values '01' and '11' (e.g. a middle point between the voltage levels corresponding to '01' and '11'). The voltage within a reference voltage level Vref centered around the first voltage level VR1 may be referred to as the first unreliable voltage level. The second voltage level VR2 may refer to the middle of the voltage levels corresponding to the PAM-4 symbol values '11' and '10' (e.g. a middle point between the voltage levels corresponding to '11' and '10'). The voltage within the reference voltage level Vref centered around the second voltage level VR2 may be referred to as the second unreliable voltage level. The third voltage level VR3 may refer to the middle of the voltage levels corresponding to the PAM-4 symbol values '10' and '00' (e.g. a middle point between the voltage levels corresponding to '10' and '00'). The voltage within the reference voltage level Vref centered around the third voltage level VR3 may be referred to as the third unreliable voltage level.

The reliability calculator 124 may generate the first to third bit stream information bs1 to bs3 based on whether the PAM-4 symbols corresponding to the symbols of the first to third packet fragments PF1 to PF3 have unreliable voltage levels.

For example, the reliability calculator 124 may receive the first packet fragment PF1. The first packet fragment PF1 may include first to K-th symbols. "K" may represent the number of symbols of the first packet fragment PF1. For example, "K" may be 86. Each of the first to K-th symbols may include four PAM-4 symbols. A J-th symbol may refer to one of the first to K-th symbols. "J" is a natural number less than or equal to "K".

The reliability calculator 124 may determine whether at least one of the four PAM-4 symbols corresponding to the J-th symbol among the first to K-th symbols has an unreliable voltage level (e.g. has a voltage level falling within a range of unreliable voltages). In response to determining that at least one of the four PAM-4 symbols corresponding to the J-th symbol has an unreliable voltage level, the reliability calculator 124 may set a bit corresponding to the J-th symbol among "K" bits of the first bit stream information bs1 to a first bit value (e.g., '1'). In response to determining that none of the four PAM-4 symbols corresponding to the J-th symbol have an unreliable voltage level, the reliability calculator 124 may set a bit corresponding to the J-th symbol among the "K" bits of the first bit stream information bs1 to a second bit value (e.g., '0').

As in the above description, the reliability calculator 124 may generate the second bit stream information bs2 based on the voltage levels of the PAM-4 symbols corresponding to the symbols of the second packet fragment PF2. The reliability calculator 124 may generate the third bit stream information bs3 based on the voltage levels of the PAM-4 symbols corresponding to the symbols of the third packet fragment PF3.

FIG. 5 is a table illustrating a packet of a flit mode, according to some embodiments. Referring to FIG. 5, a packet in the flit mode may include 256 symbols. The 256 symbols may be transmitted through 16 data lanes. For example, in FIG. 3, "N" may be 16, and the first communication device 100 may receive 256 symbols through first to 16th data lanes.

Referring to the table, the symbols transmitted for each data lane are described. An item in a row direction may represent a byte index value. Byte index values '0:255' may uniquely represent a corresponding one of the 256 symbols of the packet, respectively. An item in a column direction may represent a data lane index value. Data lane index values '1:16' may uniquely represent a corresponding one of the first to 16th data lanes transmitting the packet, respectively.

The 256 symbols of the packet in the flit mode may refer to 236 TLP symbols 'TLP0:TLP235', 6 DLP symbols 'DLP0:DLP5', 8 CRC parity symbols 'CRC0:CRC7', and 6 ECC parity symbols 'ECC1a, ECC1b, ECC2a, ECC2b, ECC3a, and ECC3b'. Each of the 256 symbols may correspond to one of the first packet fragment PF1, the second packet fragment PF2, and the third packet fragment PF3 of FIG. 3. Depending on the type of packet fragment corresponding to each symbol, the symbols are depicted as different types (e.g., dark shading, light shading, or no shading).

To help understanding of the present disclosure, the 256 symbols are described based on 16 data lanes, but the scope of the present disclosure is not limited thereto and embodiments are not limited thereto. In some embodiments, the number of data lanes may be changed to more or less than 16.

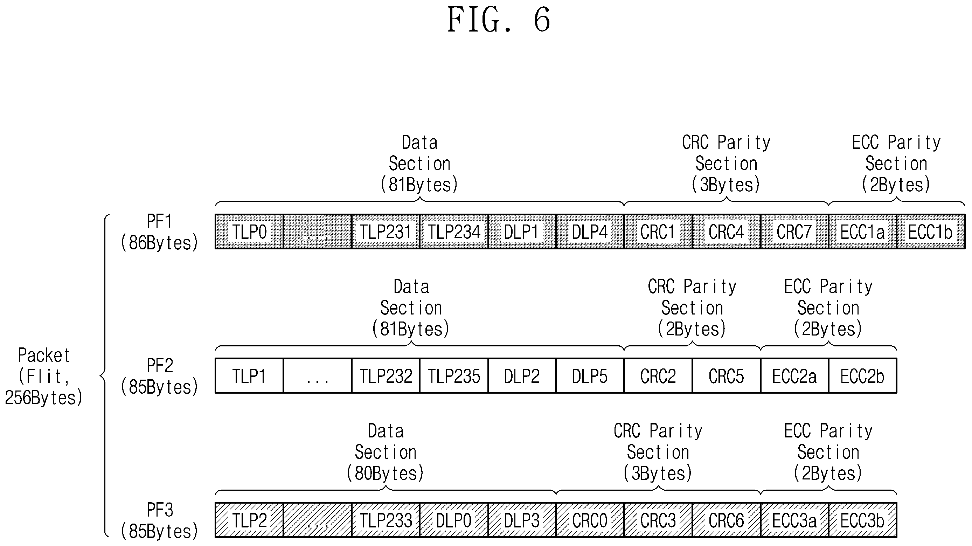

FIG. 6 is a diagram illustrating packet fragments of a packet of a flit mode, according to some embodiments. Referring to FIGS. 5 and 6, a packet in the flit mode may include the first packet fragment PF1, the second packet fragment PF2, and the third packet fragment PF3. Symbols corresponding to the first packet fragment PF1 are illustrated with dark shading. Symbols corresponding to the second packet fragment PF2 are illustrated with no shading. Symbols corresponding to the third packet fragment PF3 are illustrated with light shading.

The first packet fragment PF1 may have a size of 86 bytes. The first packet fragment PF1 may include a data section having a size of 81 bytes, a CRC parity section having a size of 3 bytes, and an ECC parity section having a size of 2 bytes.

The first packet fragment PF1 may include 86 symbols. The 86 symbols of the first packet fragment PF1 may include 79 TLP symbols 'TLP0, ... , TLP231, and TLP234', two DLP symbols 'DLP1 and DLP4', three CRC parity symbols 'CRC1, CRC4, and CRC7', and two ECC parity symbols 'ECC1a and ECC1b'.

The 79 TLP symbols 'TLP0, ... , TLP231, and TLP234' and two DLP symbols 'DLP1 and DLP4' may correspond to the data section. The three CRC parity symbols 'CRC1, CRC4, and CRC7' may correspond to the CRC parity section. The two ECC parity symbols 'ECC1a and ECC1b' may correspond to the ECC parity section.

The second packet fragment PF2 may have a size of 85 bytes. The second packet fragment PF2 may include a data section having a size of 81 bytes, a CRC parity section having a size of 2 bytes, and an ECC parity section having a size of 2 bytes.

The second packet fragment PF2 may include 85 symbols. The 85 symbols of the second packet fragment PF2 may refer to 79 TLP symbols 'TLP1, ... , TLP232, and TLP235', two DLP symbols 'DLP2 and DLP5', two CRC parity symbols 'CRC2 and CRC5', and two ECC parity symbols 'ECC2a and ECC2b'.

The 79 TLP symbols 'TLP1, ... , TLP232, and TLP235' and two DLP symbols 'DLP2 and DLP5' may correspond to the data section. The two CRC parity symbols 'CRC2 and CRC5' may correspond to the CRC parity section. The two ECC parity symbols 'ECC2a and ECC2b' may correspond to the ECC parity section.

The third packet fragment PF3 may have a size of 85 bytes. The third packet fragment PF3 may include a data section having a size of 80 bytes, a CRC parity section having a size of 3 bytes, and an ECC parity section having a size of 2 bytes.

The third packet fragment PF3 may include 85 symbols. The 85 symbols of the third packet fragment PF3 may refer to 78 TLP symbols 'TLP2, ... , and TLP233', two DLP symbols 'DLP0 and DLP3', three CRC parity symbols 'CRC0, CRC3, and CRC6', and two ECC parity symbols 'ECC3a and ECC3b'.

The 78 TLP symbols 'TLP2, ... , and TLP233' and two DLP symbols 'DLP0 and DLP3' may correspond to the data section. The three CRC parity symbols 'CRC0, CRC3, and CRC6' may correspond to the CRC parity section. The two ECC parity symbols 'ECC3a and ECC3b' may correspond to the ECC parity section.

FIG. 7 is a diagram illustrating interleaved packets, according to some embodiments. Referring to FIGS. 3 and 7, the interleaved packet PI may include 250 symbols. The interleaver circuit 123 may transmit the interleaved packet PI to the CRC decoder 121 through first to fourth interleaver lanes.

Referring to the table, the symbols transmitted for each interleaver lane are described. An item in a row direction may represent a byte index value. Byte index values '0:249' may uniquely represent a corresponding one of the 250 symbols of the interleaved packet PI, respectively. An item in a column direction may represent an interleaver lane index value. The interleaver lane index values '1:4' may uniquely represent one of the first to fourth interleaver lanes that transmit the interleaved packet PI, respectively.

The 250 symbols of the interleaved packet PI may include 236 TLP symbols 'TLP0:TLP235', 6 DLP symbols 'DLP0:DLP5', and 8 CRC parity symbols 'CRC0:CRC7'. Depending on the type of packet fragment corresponding to each symbol, the symbols are depicted as different types (e.g., dark shading, light shading, or no shading).

To help understanding of the present disclosure, the interleaved packet PI is described based on four interleaver lanes, but the scope of the present disclosure is not limited thereto and embodiments are not limited thereto. In some embodiments, the number of interleaver lanes may be changed to more or less than four.

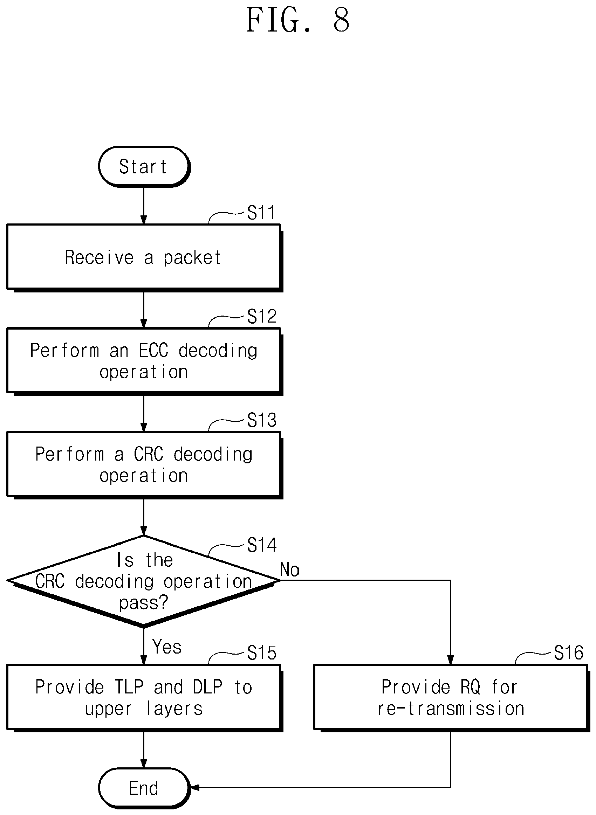

FIG. 8 is a flowchart illustrating how a flit decoder operates. Referring to FIG. 8, a communication device may communicate with another communication device through a communication interface circuit. The communication device may include a general flit decoder. Although a general flit decoder is described to help understand the present disclosure, the general flit decoder may include technical features not disclosed in prior literature. The general flit decoder is not intended to limit the scope of the present disclosure.

In operation S11, the general flit decoder may receive a packet from another communication device. The packet may comply with the format of the flit mode of the PCIe standard. The packet may include a plurality of packet fragments.

In operation S12, the general flit decoder may perform an ECC decoding operation on the packet. For example, the general flit decoder may generate a plurality of ECC decoded packet fragments based on the plurality of packet fragments, and may generate an interleaved packet fragment based on the plurality of ECC decoded packet fragments.

In operation S13, the general flit decoder may perform a CRC decoding operation based on the interleaved packet fragments.

In operation S14, the general flit decoder may determine whether the CRC decoding operation passes or fails. When the CRC decoding operation passes (S14, Yes), the general flit decoder may perform operation S15.

In operation S15, the general flit decoder may provide the CRC decoded packet to upper layers. The CRC decoded packet may include the TLP and the DLP. The upper layers may refer to the transaction layer TL1 and the data link layer DL1 of FIG. 1.

On the other hand, when the CRC decoding operation fails (S14, No), the general flit decoder may perform operation S16.

In operation S16, the general flit decoder may generate the request signal RQ for re-transmission of the packet, and may provide the request signal RQ to another communication device. The re-transmission of the packet may reduce the communication speed of the electronic system including the communication device. A technique for reducing a re-transmission rate of the packet may be used.

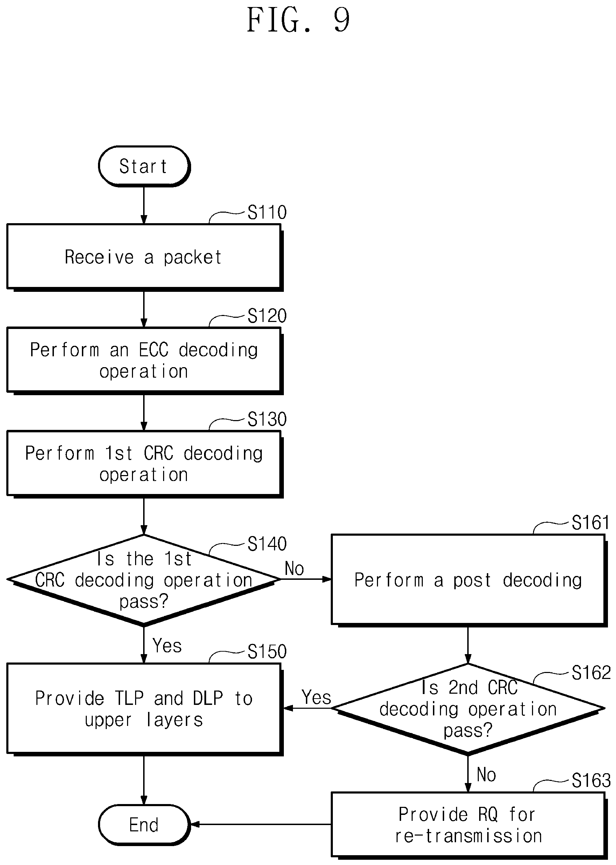

FIG. 9 is a flowchart illustrating a method of operating a flit decoder, according to some embodiments. Referring to FIG. 9, a communication device may communicate with another communication device through a communication interface circuit. The communication device may include a flit decoder. For example, in an embodiment, the flit decoder may be the flit decoder 120 described with reference to FIGS. 1-7.

In operation S110, the flit decoder may receive a packet from the other communication device. The packet may comply with the format of the flit mode of the PCIe standard. The packet may include a plurality of packet fragments.

In operation S120, the flit decoder may perform an ECC decoding operation on the packet. For example, the flit decoder may generate a plurality of ECC decoded packet fragments based on the plurality of packet fragments, and may generate a first interleaved packet fragment based on the plurality of ECC decoded packet fragments.

In operation S130, the flit decoder may perform a first CRC decoding operation based on the first interleaved packet fragment.

In operation S140, the flit decoder may determine whether the first CRC decoding operation passes or fails. When the first CRC decoding operation passes (S140, Yes), the flit decoder may perform operation S150.

In operation S150, the flit decoder may provide the CRC decoded packet to upper layers. The CRC decoded packet may include the TLP and the DLP. The upper layers may refer to the transaction layer TL1 and the data link layer DL1 of FIG. 1.

On the other hand, when the first CRC decoding operation fails (S140, No), the flit decoder may perform operation S161.

In operation S161, the flit decoder may perform a post decoding operation. The post decoding operation may refer to performing erasure decoding operations on combinations of estimated error symbols, and selecting one of the erasure decoded packet fragments obtained by the erasure decoding operations as the post decoded packet fragment. The error correction capability of the erasure decoding operation may be greater than the error correction capability of the ECC decoding operation.

The post decoded packet fragment may replace one of the ECC decoded packet fragments obtained by the ECC decoding operation of operation S120. For example, the flit decoder may generate a second interleaved packet based on the post decoded packet fragment instead of the ECC decoded packet fragment.

In operation S162, the flit decoder may perform a second CRC operation based on the second interleaved packet. The flit decoder may determine whether the second CRC decoding operation passes or fails. When the second CRC decoding operation passes (S162, Yes), the flit decoder may perform operation S150 based on the CRC decoded packet obtained by the second CRC decoding operation.

On the other hand, the second CRC decoding operation fails (S162, No), the flit decoder may perform operation S163.

In operation S163, the flit decoder may generate the request signal RQ for re-transmission of the packet, and may provide the request signal RQ to another communication device. In other words, the flit decoder may perform a post decoding operation instead of requesting re-transmission of the packet when the first CRC decoding operation fails. Since the error correction capability of the post decoding operation is greater than the error correction capability of the ECC decoding operation, the re-transmission rate of the packet may be reduced by the post decoding operation.

In more detail, the post decoding operation may include erasure decoding operations for combinations of error-estimated symbols. The error correction capability of the erasure decoding operation may be greater than the error correction capability of the ECC decoding operation. By performing erasure decoding operations, the error correction capability of the flit decoder may be increased and the re-transmission rate of the packet may be reduced.

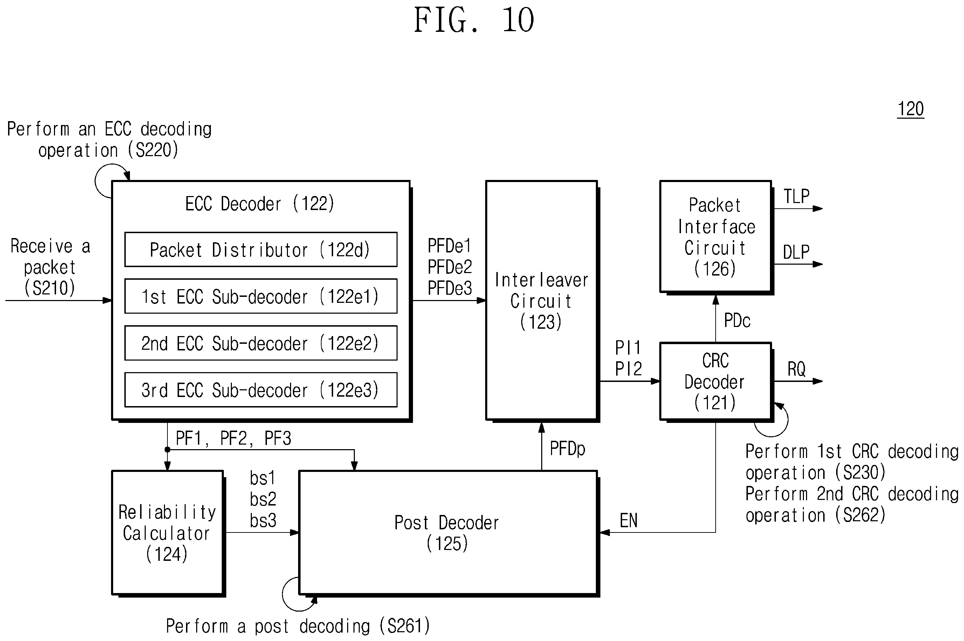

FIG. 10 is a diagram illustrating a method of operating a flit decoder, according to some embodiments. Referring to FIG. 10, the flit decoder 120 may include the CRC decoder 121, the ECC decoder 122, the interleaver circuit 123, the reliability calculator 124, the post decoder 125, and the packet interface circuit 126. The ECC decoder 122 may include the packet distributor 122d, the first ECC sub-decoder 122e1, the second ECC sub-decoder 122e2, and the third ECC sub-decoder 122e3.

In operation S210, the ECC decoder 122 may receive a packet. The packet may comply with the format of the flit mode of the PCIe standard. The packet may include the first to third packet fragments PF1 to PF3.

In operation S220, the ECC decoder 122 may perform an ECC decoding operation of the packet. For example, the packet distributor 122d may generate the first to third packet fragments PF1 to PF3 based on the distribution operation of the packet. The first to third ECC sub-decoders 122e1 to 122e3 may generate the first to third ECC decoded packet fragments PFDe1 to PFDe3 based on the first to third packet fragments PF1 to PF3, respectively.

The ECC decoder 122 may provide the first to third packet fragments PF1 to PF3 to the reliability calculator 124 and the post decoder 125. The reliability calculator 124 may provide the first to third bit stream information bs1 to bs3 to the post decoder 125 based on the first to third packet fragments PF1 to PF3.

The ECC decoder 122 may provide the first to third ECC decoded packet fragments PFDe1 to PFDe3 to the interleaver circuit 123. The interleaver circuit 123 may generate a first interleaved packet PI1 based on the interleaving operation of the first to third ECC decoded packet fragments PFDe1 to PFDe3. The interleaver circuit 123 may provide the first interleaved packet PI1 to the CRC decoder 121.

In operation S230, the CRC decoder 121 may perform the first CRC decoding operation of the first interleaved packet PI1. The CRC decoder 121 may determine whether the first CRC decoding operation passes or fails.

In response to the passing of the first CRC decoding operation, the CRC decoder 121 may provide the CRC decoded packet PDc generated by the first CRC decoding operation to the packet interface circuit 126. The packet interface circuit 126 may generate the TLP and the DLP based on the CRC decoded packet PDc, may provide the TLP to the transaction layer TL1 of FIG. 1, and may provide the DLP to the data link layer DL1 of FIG. 1.

In response to the failure of the first CRC decoding operation, the CRC decoder 121 may provide the enable signal EN to the post decoder 125.

In operation S261, the post decoder 125 may perform a post decoding operation based on the first to third bit stream information bs1 to bs3 and the first to third packet fragments PF1 to PF3 in response to the enable signal EN, may generate at least one post decoded packet fragment PFDp based on the post decoding operation, and may provide at least one post decoded packet fragment PFDp to the interleaver circuit 123. The at least one post decoded packet fragment PFDp may replace at least one of the first to third ECC decoded packet fragments PFDe1 to PFDe3 in the interleaver circuit 123.

The interleaver circuit 123 may generate a second interleaved packet PI2 based on the at least one post decoded packet fragment PFDp and some of the first to third ECC decoded packet fragments PFDe1 to PFDe3 that are not replaced. The interleaver circuit 123 may provide the second interleaved packet PI2 to the CRC decoder 121.

In operation S262, the CRC decoder 121 may perform the second CRC decoding operation of the second interleaved packet PI2. The CRC decoder 121 may determine whether the second CRC decoding operation passes or fails.

In response to the passing of the second CRC decoding operation, the CRC decoder 121 may provide the CRC decoded packet PDc generated by the second CRC decoding operation to the packet interface circuit 126. The packet interface circuit 126 may generate the TLP and the DLP based on the CRC decoded packet PDc, may provide the TLP to the transaction layer TL1 of FIG. 1, and may provide the DLP to the data link layer DL1 of FIG. 1.

The CRC decoder 121 may generate the request signal RQ for re-transmission of the packet of operation S210 in response to a failure of the second CRC decoding operation. The CRC decoder 121 may provide the request signal RQ to the second communication device 200 of FIG. 1.

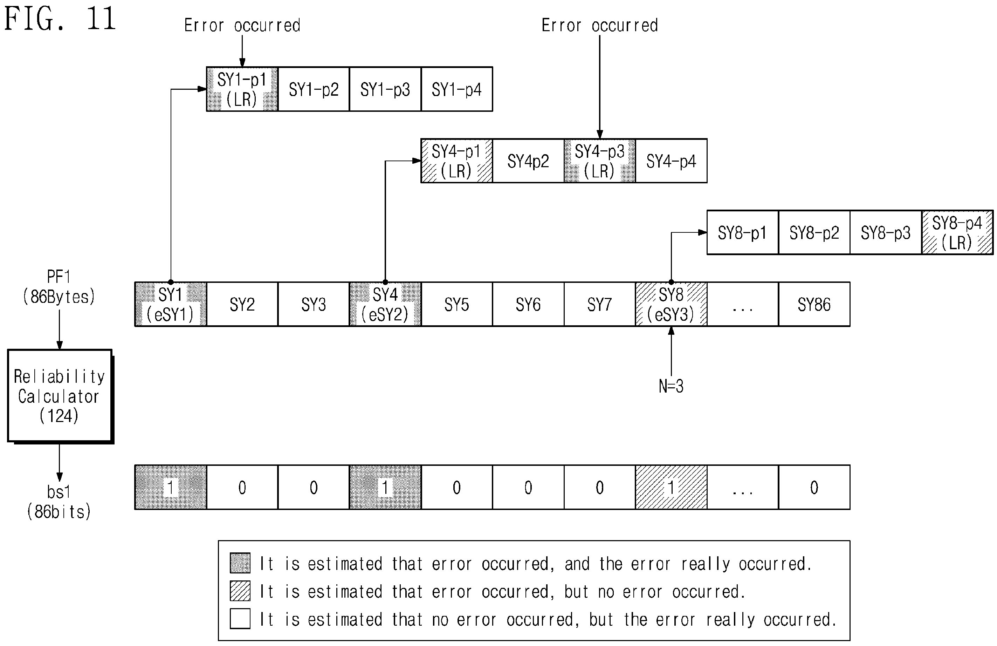

FIG. 11 is a diagram illustrating a bit stream information of FIG. 10, according to some embodiments. Referring to FIGS. 10 to 11, the reliability calculator 124 may generate the first bit stream information bs1 based on the first packet fragment PF1.

The first packet fragment PF1 may have a size of 86 bytes. The first packet fragment PF1 may include first to 86th symbols SY1 to SY86. The first to 86th symbols SY1 to SY86 may each correspond to four PAM-4 symbols.

The first packet fragment PF1 may include "N" error-estimated symbols. "N" is a natural number less than the number (i.e., 86) of symbols of the first packet fragment PF1. For example, among the first to 86th symbols SY1 to SY86 of the first packet fragment PF1, the first, the fourth, and the eighth symbols SY1, SY4, and SY8 may be error-estimated symbols. The first, the fourth, and the eighth symbols SY1, SY4, and SY8 may be referred to as first, second, and third error-estimated symbols eSY1, eSY2, and eSY3, respectively. In this case, "N" may be '3'.

The first symbol SY1 may include first to fourth PAM-4 symbols SY1-p1 to SY1-p4. The first PAM-4 symbol SY1-p1 may have an unreliable voltage level. An error may occur in the first PAM-4 symbol SY1-p1. The symbol in which an error is estimated to have occurred and an error actually occurs is illustrated in dark shading. The first PAM-4 symbol SY1-p1 may also be referred to as a low reliability symbol LR. The second to fourth PAM-4 symbols SY1-p2 to SY1-p4 may not have unreliable voltage levels.

The reliability calculator 124 may set the bit corresponding to the first symbol SY1 to a first bit value (e.g., '1') when at least one of the first to fourth PAM-4 symbols SY1-p1 to SY1-p4 of the first symbol SY1 is the low reliability symbol LR. For example, among the 86 bits of the first bit stream information bs1, the first bit corresponding to the first symbol SY1 may be set to '1'.

The fourth symbol SY4 may include first to fourth PAM-4 symbols SY4-p1 to SY4-p4. The first PAM-4 symbol SY4-p1 may have an unreliable voltage level. An error may not occur in the first PAM-4 symbol SY4-p1. A symbol in which an error is estimated to have occurred, but in which an error does not occur, is illustrated in a light shading. The first PAM-4 symbol SY4-p1 may also be referred to as the low reliability symbol LR. An error may occur in the third PAM-4 symbol SY4-p3. The third PAM-4 symbol SY4-p3 may also be referred to as the low reliability symbol LR. The second and fourth PAM-4 symbols SY4-p2 and SY4-p4 may not have unreliable voltage levels.

The reliability calculator 124 may set the bit corresponding to the fourth symbol SY4 to a first bit value (e.g., '1') when at least one of the first to fourth PAM-4 symbols SY4-p1 to SY4-p4 of the fourth symbol SY4 is the low reliability symbol LR. For example, among the 86 bits of the first bit stream information bs1, the fourth bit corresponding to the fourth symbol SY4 may be set to '1'.

The eighth symbol SY8 may include first to fourth PAM-4 symbols SY8-p1 to SY8-p4. The fourth PAM-4 symbol SY8-p4 may have an unreliable voltage level. An error may not occur in the fourth PAM-4 symbol SY8-p4. The fourth PAM-4 symbol SY8-p4 may also be referred to as the low reliability symbol LR. The first, second, and third PAM-4 symbols SY8-p1, SY8-p2, and SY8-p3 may not have unreliable voltage levels.

The reliability calculator 124 may set the bit corresponding to the eighth symbol SY8 to a first bit value (e.g., '1') when at least one of the first to fourth PAM-4 symbols SY8-p1 to SY8-p4 of the eighth symbol SY8 is the low reliability symbol LR. For example, among the 86 bits of the first bit stream information bs1, the eighth bit corresponding to the eighth symbol SY8 may be set to '1'.

The reliability calculator 124 may set each of the bits corresponding to the symbols that do not have the low reliability symbol LR among the first to 86 symbols SY1 to SY86 of the first packet fragment PF1 to a second bit value (e.g., '0'). For example, among the 86 bits of the first bit stream information bs1, the bits corresponding to the second, third, fifth to seventh, and ninth to 86th symbols SY2, SY3, SY5 to SY7, and SY9 to SY86 may be set to '0'.

To avoid the complexity of the description, the reliability calculator 124 is described as generating the first bit stream information bs1 based on the first packet fragment PF1, but the reliability calculator 124 may generate the second and third bit stream information bs2 and bs3 based on the second and third packet fragments PF2 and PF3 in a similar manner as described above and thus repeated description thereof is omitted for conciseness.

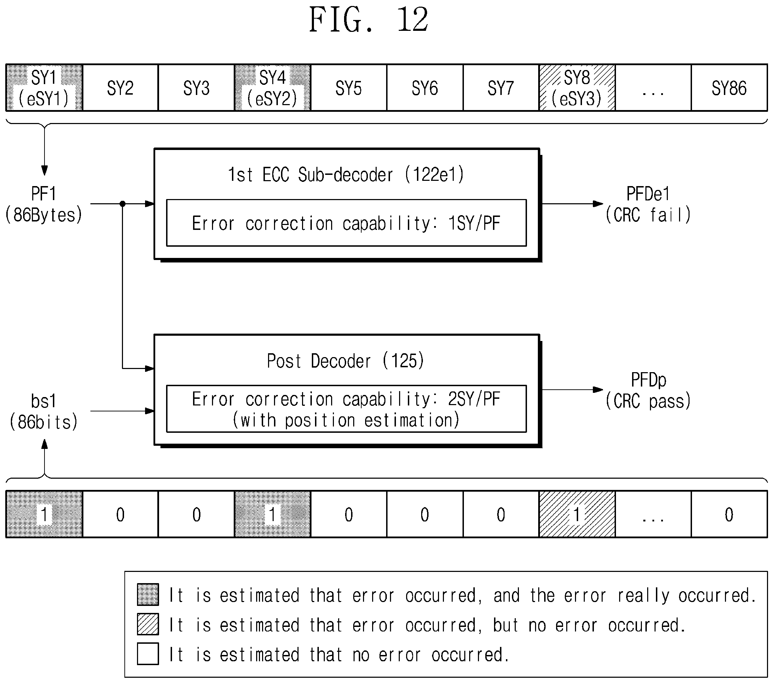

FIG. 12 is a diagram illustrating a decoded packet fragment of FIG. 10, according to some embodiments. Referring to FIG. 10 and FIG. 12, the first ECC sub-decoder 122e1 may generate the first ECC decoded packet fragment PFDe1 based on the ECC decoding operation of the first packet fragment PF1. The post decoder 125 may generate the post decoded packet fragment PFDp based on the first packet fragment PF1 and the first bit stream information bs1.

The first packet fragment PF1 may have a size of 86 bytes. The first packet fragment PF1 may include the first to 86th symbols SY1 to SY86. The first, the fourth, and the eighth symbols SY1, SY4, and SY8 may be referred to as first, second, and third error-estimated symbols eSY1, eSY2, and eSY3, respectively. An error may actually have occurred in the first and fourth symbols SY1 and SY4. The first and fourth symbols SY1 and SY4 may also be referred to as error symbols. An error may not have occurred in the eighth symbol SY8. The symbol in which an error is estimated to have occurred and an error actually occurs is illustrated in dark shading. A symbol in which an error is estimated to have occurred, but in which an error does not occur, is illustrated in a light shading.

The first bit stream information bs1 may include the first to 86th bits corresponding to the first to 86th symbols SY1 to SY86 of the first packet fragment PF1. Among the first to 86th bits, the first, the fourth, and the eighth bits may have a first bit value (e.g., '1'), and the remaining bits may have a second bit value (e.g., '0').

The error correction capability of the first ECC sub-decoder 122e1 may correspond to one symbol per packet fragment. For example, the first ECC sub-decoder 122e1 may correct one error symbol among the first to 86th symbols SY1 to SY86 of the first packet fragment PF1. Since the first packet fragment PF1 includes two error symbols (i.e., the first and the fourth symbols SY1 and SY4), the error level of the first packet fragment PF1 may exceed the error correction capability of the first ECC sub-decoder 122e1. The CRC decoder 121 may fail the CRC decoding operation based on the first ECC decoded packet fragment PFDe1.

The error correction capability of the post decoder 125 may correspond to two symbols per packet fragment. The post decoder 125 may request position estimation of two error symbols. For example, the post decoder 125 may correct two error symbols whose positions are estimated among the first to 86th symbols SY1 to SY86 of the first packet fragment PF1. The post decoder 125 may estimate the positions of the two error symbols based on the first bit stream information bs1. The first packet fragment PF1 may include two error symbols (i.e., the first and the fourth symbols SY1 and SY4). The error level of the first packet fragment PF1 may not exceed the error correction capability of the post decoder 125. The CRC decoder 121 may pass a CRC decoding operation based on the post decoded packet fragment PFDp that replaces the first ECC decoded packet fragment PFDe1.

To avoid complexity of description, the ECC decoding operation and the post decoding operation are described with respect to the first packet fragment PF1, but the ECC decoding operation and the post decoding operation may be performed in a similar manner for the second packet fragment PF2 and the third packet fragment PF3 and thus repeated description thereof is omitted for conciseness.

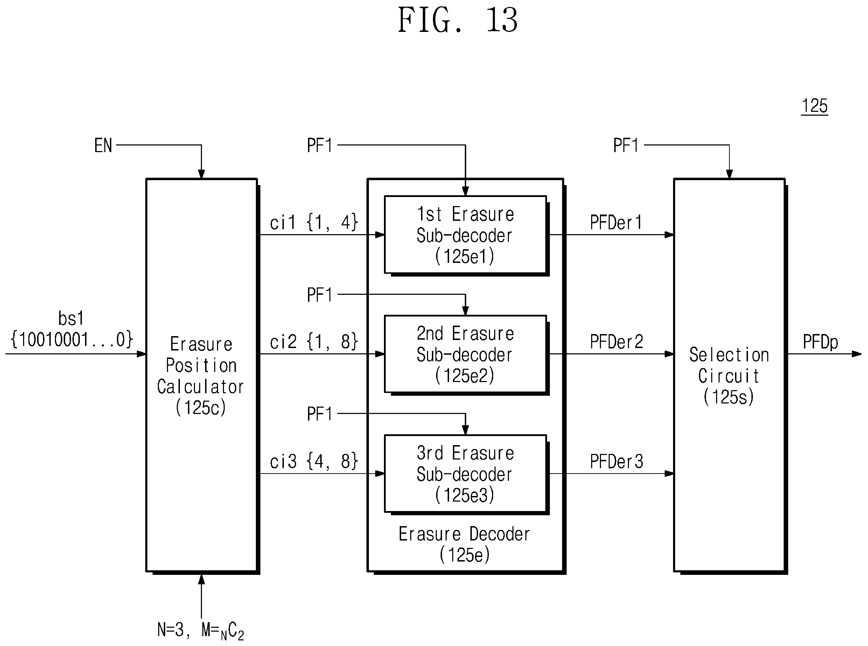

FIG. 13 is a diagram illustrating a post decoder of FIG. 10, according to some embodiments. Referring to FIG. 10 and FIG. 13, the post decoder 125 may generate the post decoded packet fragment PFDp based on the enable signal EN, the first bit stream information bs1, and the first packet fragment PF1. The first bit stream information bs1 may identify "N" error-estimated symbols among the first to 86th symbols of the first packet fragment PF1. For example, the first symbol, the fourth symbol, and the eighth symbol among the first to 86th symbols may be referred to as first to third error-estimated symbols, respectively. For instance, "N" may be 3. The first and the fourth symbols may be symbols in which errors actually occur. The eighth symbol may be a symbol in which an error is estimated to have occurred, but in which an error does not occur.

The post decoder 125 may include an erasure position calculator 125c, an erasure decoder 125e, and a selection circuit 125s. The erasure decoder 125e may include a first erasure sub-decoder 125e1, a second erasure sub-decoder 125e2, and a third erasure sub-decoder 125e3.

The erasure position calculator 125c may be activated in response to the enable signal EN, and may generate first to M-th candidate information based on the first bit stream information bs1 for identifying first to N-th error-estimated symbols. "M" may be a result value of an _{N}C₂ combinational arithmetic operation. For instance, each candidate information may be a unique combination of two error-estimated symbols (without considering order). "M" may be _{N}C₂ (otherwise known as "N choose 2"), which may be a number of ways to select 2 items from a set of N items, where order does not matter. For instance, _{N}C₂ may be equal to N(N-1)/2.

For example, the first to N-th error-estimated symbols may be a first symbol, a fourth symbol, and an eighth symbol of the first packet fragment PF1. For example, "N" may be 3. For example, "M" may be 3. The first to M-th candidate information may be first candidate information ci1, second candidate information ci2, and third candidate information ci3. The first candidate information ci1 may refer to first and fourth symbols. The second candidate information ci2 may refer to first and eighth symbols. The third candidate information ci3 may refer to fourth and eighth symbols. Each candidate information may represent a corresponding 2-combination (a selection of two items) from the first to N-th error estimated symbols.

The erasure decoder 125e may generate first to M-th erasure decoded packet fragments based on the first packet fragment PF1 and the first to M-th candidate information. For example, the first to M-th candidate information may be the first to third candidate information ci1 to ci3 representing two combined (e.g. 2-combinations) of the first symbol, the fourth symbol, and the eighth symbol.

In more detail, the first erasure sub-decoder 125e1 may generate a first erasure decoded packet fragment PFDer1 by performing an erasure decoding operation on the first packet fragment PF1 based on the first candidate information ci1 representing the first symbol and the fourth symbol. The erasure decoding may be performing error correction of two error symbols whose positions are specified based on the candidate information.

The first and the fourth symbols may be symbols in which errors actually occur. The first erasure decoded packet fragment PFDer1 may include symbols in which errors are corrected. In detail, the first erasure decoded packet fragment PFDer1 may not include an error symbol.

As in the above description, the second erasure sub-decoder 125e2 may generate a second erasure decoded packet fragment PFDer2 by performing an erasure decoding operation on the first packet fragment PF1 based on the second candidate information ci2 representing the first symbol and the eighth symbol. The third erasure sub-decoder 125e3 may generate a third erasure decoded packet fragment PFDer3 by performing an erasure decoding operation on the first packet fragment PF1 based on the third candidate information ci3 representing the fourth symbol and the eighth symbol.

The eighth symbol may be a symbol in which an error does not occur. The second and third erasure decoded packet fragments PFDer2 and PFDer3 may include many error symbols as the erasure decoding is performed based on the incorrectly estimated symbol (i.e., the eighth symbol).

The erasure decoder 125e is described as including the first to third erasure sub-decoders 125e1 to 125e3, but embodiments are not limited thereto. In some embodiments, the number of erasure sub-decoders included in the erasure decoder 125e may be less than or more than three. In an embodiment, the erasure sub-decoder may perform erasure decoding operations on two or more candidate information corresponding to the same bit stream information. In some embodiments, when the number of candidate information is small, some erasure sub-decoders may not perform the erasure decoding operations.

The selection circuit 125s may select one of the first to M-th erasure decoded packet fragments as the post decoded packet fragment PFDp and may provide the post decoded packet fragment PFDp to the interleaver circuit 123.

For example, the selection circuit 125s may calculate a first difference value, a second difference value, and a third difference value based on comparison operations of each of the first to third erasure decoded packet fragments PFDer1 to PFDer3 and the first packet fragment PF1. The difference value may represent the number of different bits of the packet fragment and the erasure decoded packet fragment (e.g. the number of bits that differ between packet fragment and the erasure decoded packet fragment). Since the first erasure decoded packet fragment PFDer1 is similar to the first packet fragment PF1 except for the first and fourth symbols, the first difference value may be relatively small. Since the second and third erasure decoded packet fragments PFDer2 and PFDer3 include many error symbols due to the erasure decoding based on the incorrectly estimated symbol (i.e., the eighth symbol), the second difference value and the third difference value may be relatively large.

The selection circuit 125s may select the first difference value, which is a minimum difference value among the first to third difference values, may select the first erasure decoded packet fragment PFDer1 corresponding to the first difference value as the post decoded packet fragment PFDp, and may replace the first ECC decoded packet fragment PFDe1 buffered by the interleaver circuit 123 with the post decoded packet fragment PFDp.

To avoid the complexity of the description, the post decoder 125 is described as generating the post decoded packet fragment PFDp corresponding to the first packet fragment PF1, but the post decoder 125 may generate the post decoded packet fragment PFDp based on the second packet fragment PF2 or the third packet fragment PF3.

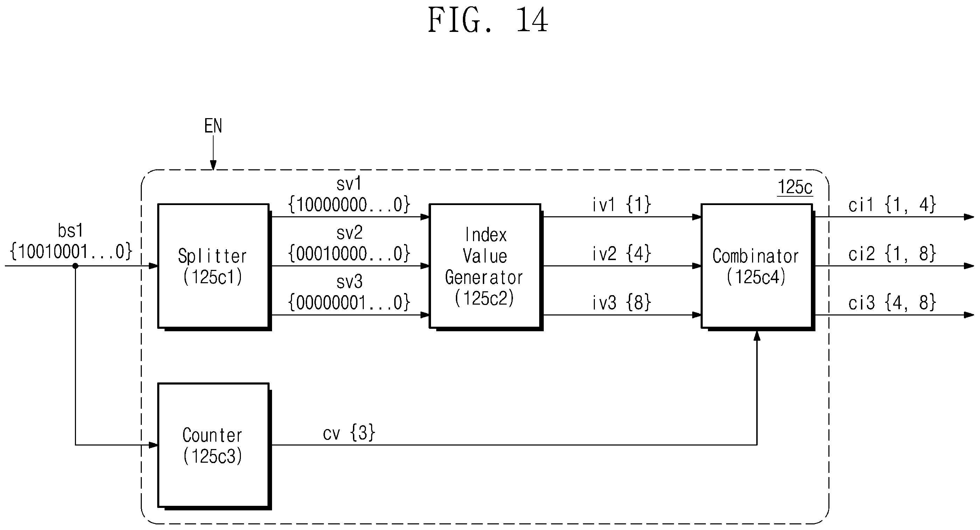

FIG. 14 is a diagram illustrating an erasure position calculator of FIG. 13, according to some embodiments. Referring to FIGS. 13 and 14, the erasure position calculator 125c may be activated in response to the enable signal EN. The erasure position calculator 125c may generate the first to M-th candidate information based on the first bit stream information bs1. For example, "M" may be 3. The erasure position calculator 125c may include a splitter 125c1, an index value generator 125c2, a counter 125c3, and a combinator 125c4.

The splitter 125c1 may receive the first bit stream information bs1 for identifying the first to N-th error-estimated symbols. The splitter 125c1 may generate the first to N-th split values, each having a bit string type, based on a one-hot encoding operation of the first bit stream information bs1.

For example, "N" may be 3. The first to third error-estimated symbols may refer to the first, the fourth, and the eighth symbols of the first packet fragment PF1, respectively. The splitter 125c1 may generate a first split value sv1, a second split value sv2, and a third split values sv3, each having a bit string type based on the one-hot encoding operation of the first bit stream information bs1.

The first split value sv1 may be a bit string in which the first bit has the first bit value and the remaining bits have the second bit value. The second split value sv2 may be a bit string in which the fourth bit has the first bit value and the remaining bits have the second bit value. The third split value sv3 may be a bit string in which the eighth bit has the first bit value and the remaining bits have the second bit value. The length (e.g., the number of bits) of each of the first to third split values sv1 to sv3 may be the same as the length of the first bit stream information bs1.

The index value generator 125c2 may generate first to N-th index values, each having an integer type, based on the type conversion operation of the first to N-th split values. The first to N-th index values may correspond to the first to N-th error-estimated symbols identified by the first bit stream information bs1, respectively.

For example, the index value generator 125c2 may generate a first index value iv1, a second index value iv2, and a third index value iv3, each having an integer type, based on a type conversion operation of the first to third split values sv1 to sv3. The type conversion may convert the split values from bit string type into integer type. The first index value iv1 may represent an integer value '1'. The second index value iv2 may represent an integer value '4'. The third index value iv3 may represent an integer value '8'.

The counter 125c3 may generate a counted value "cv" indicating "N" based on a count operation of the first bit stream information bs1. "N" may be the number of bits having the first bit value among the bits of the first bit stream information bs1. For example, the first bit stream information bs1 may include first to 86th bits. The first, the fourth, and the eighth bits may have the first bit value, and the remaining bits may have the second bit value. The counter 125c3 may generate the counted value cv indicating '3' based on a count operation of the first bit stream information bs1.

The combinator 125c4 may generate the first to M-th candidate information indicating two combined (e.g. 2-combinations) without duplication and without considering the order among the first to N-th index values. "N" may be the number of error-estimated symbols identified by the first bit stream information bs1. "M" may be _{N}C₂.

For example, the combinator 125c4 may receive the first to third index values iv1 to iv3 indicating integer values '1, 4, and 8', respectively. The combinator 125c4 may receive the counted value cv indicating '3'. The combinator 125c4 may generate the first to third candidate information ci1 to ci3 by performing an _{N}C₂ combination arithmetic operation based on the first to third index values iv1 to iv3 and the counted value cv. For instance, the combinator 125c4 may generate the first to third candidate information ci1 to ci3 by selecting each potential pair of index values, where order of selection does not matter. The first candidate information ci1 may represent the first and the fourth symbols of the first packet fragment PF1. The second candidate information ci2 may represent the first and the eighth symbols of the first packet fragment PF1. The third candidate information ci3 may represent the fourth and the eighth symbols of the first packet fragment PF1.

To avoid the complexity of the description, the erasure position calculator 125c is described as generating the first to third candidate information ci1 to ci3 corresponding to the first bit stream information bs1, but in some embodiments, the erasure position calculator 125c may generate more than or less than three pieces of candidate information based on the first bit stream information bs1. In some embodiments, the erasure position calculator 125c may generate other candidate information based on the second and the third bit stream information bs2 and bs3.

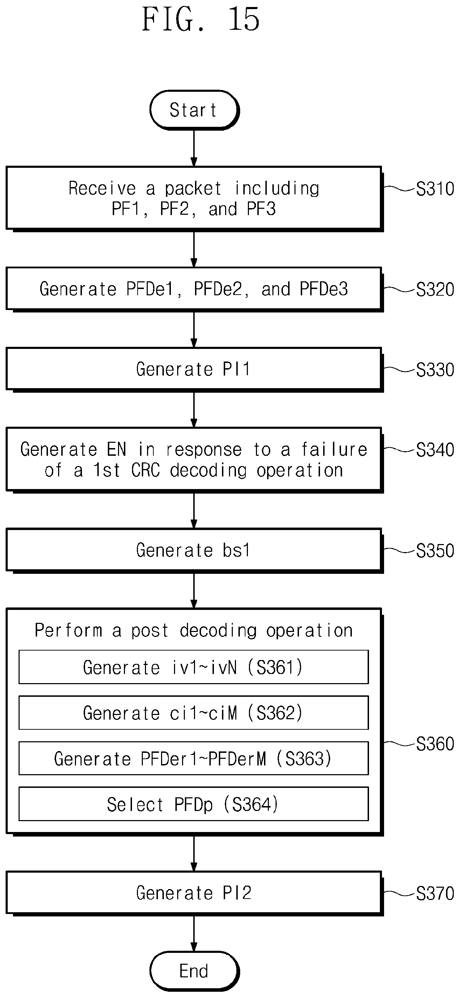

FIG. 15 is a flowchart illustrating a method of operating a flit decoder, according to some embodiments. Referring to FIG. 15, a communication device may communicate with another communication device through a communication interface circuit. The communication device may include a flit decoder. The flit decoder may be the flit decoder 125 illustrated in FIGS. 13-14.

In operation S310, the flit decoder may receive a packet including the first packet fragment PF1, the second packet fragment PF2, and the third packet fragment PF3.

In operation S320, the flit decoder may generate the first, the second, and the third ECC decoded packet fragments PFDe1, PFDe2, and PFDe3 based on the first, the second, and the third packet fragments PF1, PF2, and PF3.

In operation S330, the flit decoder may generate the first interleaved packet PI1 based on the first, the second, and the third ECC decoded packet fragments PFDe1, PFDe2, and PFDe3.

In operation S340, the flit decoder may perform a first CRC decoding operation on the first interleaved packet PI1. The flit decoder may generate the enable signal EN in response to a failure of the first CRC decoding operation. For example, the first packet fragment PF1 may include the first to K-th symbols. The first to K-th symbols may include the first to N-th error-estimated symbols. Two of the first to N-th error-estimated symbols may be error symbols. The first CRC decoding operation may fail based on two error symbols of the first packet fragment PF1. "K" may represent the number of symbols of the first packet fragment PF1. "N" may represent the number of error-estimated symbols, and may be less than "K".

In operation S350, the flit decoder may generate the first bit stream information bs1 for identifying the first to N-th error-estimated symbols among the first to K-th symbols of the first packet fragment PF1.

In operation S360, the flit decoder may perform a post decoding operation based on the enable signal EN, the first bit stream information bs1, and the first packet fragment PF1. Operation S360 may include operation S361 to operation S364.

In operation S361, the flit decoder may generate first to N-th index values iv1 to ivN corresponding to the first to N-th error-estimated symbols, respectively, based on the enable signal EN and the first bit stream information bs1.

For example, the flit decoder may generate first to N-th split values, each having a bit string type, based on a one-hot encoding operation of the first bit stream information bs1. The flit decoder may generate first to N-th index values, each having an integer type, based on a type conversion operation of the first to N-th split values.

In operation S362, the flit decoder may generate first to M-th candidate information ci1 to ciM, each indicating two of the first to N-th index values iv1 to ivN combined without duplication and without considering the order. "M" may be _{N}C₂.

For example, the flit decoder may generate a counted value corresponding to "N" based on a count operation of the first bit stream information bs1. The flit decoder may generate the first to M-th candidate information ci1 to ciM by performing an _{N}C₂ combinational arithmetic operation based on the first to N-th index values iv1 to ivN and the counted value.

In operation S363, the flit decoder may generate the first to M-th erasure decoded packet fragments PFDer1 to PFDerM based on the first packet fragment PF1 and the first to M-th candidate information ci1 to ciM.

In operation S364, the flit decoder may select one of the first to M-th erasure decoded packet fragments PFDer1 to PFDerM as the post decoded packet fragment PFDp. The post decoded packet fragment PFDp may replace the first ECC decoded packet fragment PFDe1.

In operation S370, the flit decoder may generate the second interleaved packet PI2 based on the post decoded packet fragment PFDp, the second ECC decoded packet fragment PFDe2, and the third ECC decoded packet fragment PFDe3.

Thereafter, the flit decoder may perform a second CRC decoding operation based on the second interleaved packet PI2. In response to the passing of the second CRC decoding operation, the flit decoder may obtain the TLP and the DLP from the CRC decoded packet, and may provide the TLP and the DLP to upper layers. In response to the failure of the second CRC decoding operation, the flit decoder may generate a request signal for re-transmission of the packet.

According to various embodiments, a flit decoder for generating a decoded packet fragment, a communication device including the same, and a method of operating the same are provided.

According to various embodiments, a flit decoder, a communication device including the same, and a method of operating the same are provided, in which an error correction capability is increased and a re-transmission rate of a packet is reduced by performing an erasure decoding operation on combinations of error-estimated symbols.

Embodiments are set out in the following Clauses:
Clause 1. A communication device comprising:
   an input/output (I/O) circuit including a plurality of transmitters and a plurality of receivers;
   a flit encoder configured to provide a first packet to the plurality of transmitters; and
   a flit decoder configured to receive a second packet from the plurality of receivers,
   wherein the flit decoder includes:
      an error correction code (ECC) decoder configured to generate an ECC decoded packet fragment based on a packet fragment of the second packet;
      an interleaver circuit configured to generate an interleaved packet based on the ECC decoded packet fragment;
      a cyclic redundancy check (CRC) decoder configured to generate an enable signal based on a failure of a CRC decoding operation of the interleaved packet;
      a reliability calculator configured to generate bit stream information for identifying first to N-th error-estimated symbols among a plurality of symbols of the packet fragment; and
      a post decoder configured to:
         in response to the enable signal, generate first to N-th index values corresponding to the first to N-th error-estimated symbols, respectively, based on the bit stream information;
      generate first to M-th candidate information indicating two of the first to N-th index values, which are combined without duplication and without considering an order;
      generate first to M-th erasure decoded packet fragments based on the first packet and the first to M-th candidate information; and
      provide a selected one of the first to M-th erasure decoded packet fragments to the interleaver circuit,
   wherein "N" is a natural number less than a number of the plurality of symbols, and
   wherein "M" is _{N}C₂.
Clause 2. The communication device of Clause 1, wherein the post decoder includes:
   an erasure position calculator configured to be activated based on the enable signal and to generate the first to M-th candidate information based on the bit stream information;
   an erasure decoder configured to generate the first to M-th erasure decoded packet fragments by performing erasure decoding operations on the packet fragment based on the first to M-th candidate information; and
   a selection circuit configured to select the one of the first to M-th erasure decoded packet fragments having a minimum difference value as a post decoded packet fragment based on comparison operations of each of the first to M-th erasure decoded packet fragments and the packet fragment, and to replace the ECC decoded packet fragment buffered by the interleaver circuit with the post decoded packet fragment.
Clause 3. The communication device of Clause 2, wherein the erasure position calculator includes:
   a splitter configured to generate first to N-th split values, each having a bit string type based on a one-hot encoding operation of the bit stream information;
   an index value generator configured to generate the first to N-th index values, each having an integer type based on a type conversion operation of the first to N-th split values;
   a counter configured to generate a counted value corresponding to the "N" based on a count operation of the bit stream information; and
   a combinator configured to generate the first to M-th candidate information by performing an _{N}C₂ combinational arithmetic operation based on the first to N-th index values and the counted value.
Clause 4. A method of operating a flit decoder, the method comprising:
   receiving a packet including a first packet fragment, a second packet fragment, and a third packet fragment;
   generating a first error correction code (ECC) decoded packet fragment, a second ECC decoded packet fragment, and a third ECC decoded packet fragment, based on the first packet fragment, the second packet fragment, and the third packet fragment;
   generating a first interleaved packet based on the first ECC decoded packet fragment, the second ECC decoded packet fragment, and the third ECC decoded packet fragment;
   generating an enable signal based on a failure of a first cyclic redundancy check (CRC) decoding operation of the first interleaved packet;
   generating bit stream information for identifying first to N-th error-estimated symbols among a plurality of symbols of the first packet fragment, "N" being a natural number less than a number of the plurality of symbols;
   generating first to N-th index values corresponding to the first to N-th error-estimated symbols, respectively, based on the enable signal and the bit stream information;
   generating first to M-th candidate information indicating two of the first to N-th index values, which are combined without duplication and without considering an order, "M" being _{N}C₂;
   generating first to M-th erasure decoded packet fragments based on the first packet fragment and the first to M-th candidate information;
   selecting one of the first to M-th erasure decoded packet fragments as a post-decoded packet fragment; and
   generating a second interleaved packet based on the post-decoded packet fragment, the second ECC decoded packet fragment, and the third ECC decoded packet fragment.
Clause 5. The method of Clause 4, wherein generating the first to N-th index values includes:
   generating first to N-th split values, each having a bit string type based on a one-hot encoding operation of the bit stream information; and
   generating the first to N-th index values, each having an integer type based on a type conversion operation of the first to N-th split values, and
   wherein generating the first to M-th candidate information includes:
      generating a counted value corresponding to the "N" based on a count operation of the bit stream information; and
      generating the first to M-th candidate information by performing an _{N}C₂ combinational arithmetic operation based on the first to N-th index values and the counted value.
Clause 6. The method of Clause 4 or Clause 5, further comprising:
   performing a second CRC decoding operation on the second interleaved packet; and
   generating a request signal for re-transmission of the packet based on a failure of the second CRC decoding operation.

The above descriptions are detailed embodiments for carrying out the present disclosure. Embodiments in which a design is changed simply or which are easily changed may be included in the present disclosure as well as the various embodiments described above. In addition, technologies that are easily changed and implemented by using the above embodiments may be included in the present disclosure. Therefore, the scope of the present disclosure should not be limited to the above-described embodiments and should be defined by not only the claims to be described later, but also those equivalent to the claims of the present disclosure.

## Claims

1. A flit decoder comprising:
an error correction code, ECC, decoder configured to generate a first ECC decoded packet fragment based on a first packet fragment;
an interleaver circuit configured to generate a first interleaved packet based on the first ECC decoded packet fragment;
a cyclic redundancy check, CRC, decoder configured to generate an enable signal based on a failure of a first CRC decoding operation of the first interleaved packet;
a reliability calculator configured to generate bit stream information for identifying first to N-th error-estimated symbols among a plurality of symbols of the first packet fragment; and
a post decoder configured to:
in response to the enable signal, generate first to N-th index values corresponding to the first to N-th error-estimated symbols, respectively, based on the bit stream information;
generate first to M-th candidate information indicating two of the first to N-th index values, which are combined without duplication and without considering an order;
generate first to M-th erasure decoded packet fragments based on the first packet fragment and the first to M-th candidate information; and
provide a selected one of the first to M-th erasure decoded packet fragments to the interleaver circuit,
wherein "N" is a natural number less than a number of the plurality of symbols, and
wherein "M" is _{N}C₂.

2. The flit decoder of claim 1, wherein the post decoder includes:
an erasure position calculator configured to be activated based on the enable signal and to generate the first to M-th candidate information based on the bit stream information;
an erasure decoder configured to generate the first to M-th erasure decoded packet fragments by performing erasure decoding operations on the first packet fragment based on the first to M-th candidate information; and
a selection circuit configured to select the one of the first to M-th erasure decoded packet fragments having a minimum difference value as a post decoded packet fragment based on comparison operations of each of the first to M-th erasure decoded packet fragments and the first packet fragment, and to replace the first ECC decoded packet fragment buffered by the interleaver circuit with the post decoded packet fragment.

3. The flit decoder of claim 2, wherein the erasure position calculator includes:
a splitter configured to generate first to N-th split values, each having a bit string type based on a one-hot encoding operation of the bit stream information;
an index value generator configured to generate the first to N-th index values, each having an integer type based on a type conversion operation of the first to N-th split values;
a counter configured to generate a counted value corresponding to "N" based on a count operation of the bit stream information; and
a combinator configured to generate the first to M-th candidate information by performing an _{N}C₂ combinational arithmetic operation based on the first to N-th index values and the counted value.

4. The flit decoder of any preceding claim, wherein the plurality of symbols of the first packet fragment comprise first to K-th symbols,
wherein each of the first to K-th symbols includes four pulse amplitude modulation, PAM-4, symbols,
wherein the reliability calculator is configured to:
determine whether at least one of the four PAM-4 symbols corresponding to a J-th symbol among the first to K-th symbols has an unreliable voltage level;
in response to determining that the at least one of the four PAM-4 symbols has the unreliable voltage level, set a bit corresponding to the J-th symbol among bits of the bit stream information to a first bit value; and
in response to determining that none of the four PAM-4 symbols have the unreliable voltage level, set the bit corresponding to the J-th symbol among the bits of the bit stream information to a second bit value,
wherein "K" is the number of the plurality of symbols of the first packet fragment, and
wherein "J" is a natural number less than or equal to "K".

5. The flit decoder of any preceding claim, wherein the interleaver circuit is further configured to receive the selected one of the first to M-th erasure decoded packet fragments from the post decoder, and to generate a second interleaved packet based on the selected one instead of the first ECC decoded packet fragment, and
wherein the CRC decoder is further configured to perform a second CRC decoding operation on the second interleaved packet.

6. The flit decoder of claim 5, wherein the CRC decoder is further configured to generate a CRC decoded packet based on a success of the second CRC decoding operation, and
wherein the flit decoder further includes:
a packet interface circuit configured to generate a transaction layer packet, TLP, and a data link layer packet, DLP, based on the CRC decoded packet, to provide the TLP to a transaction layer, and to provide the DLP to a data link layer.

7. The flit decoder of claim 5 or claim 6, wherein the CRC decoder is further configured to generate a request signal for re-transmission of a packet including the first packet fragment based on a failure of the second CRC decoding operation.

8. The flit decoder of any preceding claim, wherein an error correction capability of the ECC decoder corresponds to one symbol per the plurality of symbols of the first packet fragment, and
wherein an error correction capability of the post decoder corresponds to two symbols, whose positions are estimated, per the plurality of symbols of the first packet fragment.

9. The flit decoder of any preceding claim, wherein the first packet fragment has a size of 86 bytes, and
wherein the first packet fragment includes 79 TLP symbols, 2 DLP symbols, 3 CRC parity symbols, and 2 ECC parity symbols.

10. The flit decoder of any of claims 1-8, wherein the first packet fragment has a size of 85 bytes, and
wherein the first packet fragment includes 79 TLP symbols, 2 DLP symbols, 2 CRC parity symbols, and 2 ECC parity symbols.

11. The flit decoder of any of claims 1-8, wherein the first packet fragment has a size of 85 bytes, and
wherein the first packet fragment includes 78 TLP symbols, 2 DLP symbols, 3 CRC parity symbols, and 2 ECC parity symbols.

12. The flit decoder of any preceding claim, wherein the ECC decoder is further configured to:
receive a packet including the first packet fragment, a second packet fragment, and a third packet fragment,
generate a second ECC decoded packet fragment based on the second packet fragment, and
generate a third ECC decoded packet fragment based on the third packet fragment, and
wherein the interleaver circuit is further configured to generate the first interleaved packet based on an interleaving operation of the first ECC decoded packet fragment, the second ECC decoded packet fragment, and the third ECC decoded packet fragment.

13. The flit decoder of claim 12, wherein the ECC decoder includes:
a packet distributor configured to generate the first packet fragment, the second packet fragment, and the third packet fragment based on a distribution operation of the packet;
a first ECC sub-decoder configured to generate the first ECC decoded packet fragment based on a first ECC decoding operation of the first packet fragment;
a second ECC sub-decoder configured to generate the second ECC decoded packet fragment based on a second ECC decoding operation of the second packet fragment; and
a third ECC sub-decoder configured to generate the third ECC decoded packet fragment based on a third ECC decoding operation of the third packet fragment.

14. The flit decoder of any preceding claim, wherein the flit decoder supports a flit mode of a peripheral component interconnect express, PCIe, standard, and
wherein the packet complies with a format of the flit mode.

15. A communication device comprising:
an input/output, I/O, circuit including a plurality of transmitters and a plurality of receivers;
a flit encoder configured to provide a first packet to the plurality of transmitters; and
a flit decoder according to any preceding claim, wherein the flit decoder is configured to receive a second packet from the plurality of receivers, and wherein the second packet comprises the first packet fragment.
